# EUROPÄISCHE PATENTSCHRIFT

(11) **EP 0 931 327 B1**
(45) Veröffentlichungstag und Bekanntmachung des Hinweises auf die Patenterteilung: **20.03.2002**
(21) Anmeldenummer: 97909192.3
(22) Anmeldetag: 25.09.1997
(51) Int. Cl.: H01G 4/38, H01G 4/40, H01L 27/01, H01C 13/02, H01C 1/16

(54) **PASSIVES NETZWERK IN CHIP-BAUFORM**
PASSIVE NETWORK IN THE FORM OF A CHIP
RESEAU PASSIF SOUS FORME DE PUCE

(30) Priorität: 27.09.1996 DE 19639947
(43) Veröffentlichungstag der Anmeldung: 28.07.1999
(73) Patentinhaber: EPCOS AG, 81541 München (DE)
(72) Erfinder: AICHHOLZER, Klaus-Dieter, A-8530 Deutschlandsberg (AT); KAINZ, Gerald, A-8010 Graz (AT)
(74) Vertreter: Epping, Wilhelm, Dipl.-Ing.
(86) Internationale Anmeldenummer: DE9702184
(87) Internationale Veröffentlichungsnummer: WO9813841

(56) Entgegenhaltungen:
- EP-A- 0 423 821
- EP-A- 0 433 176
- GB-A- 2 249 746
- US-A- 5 382 925
- US-A- 5 388 024
- US-A- 5 590 016
- PATENT ABSTRACTS OF JAPAN vol. 095, no. 001, 28.Februar 1995 & JP 06 283384 A (TAIYO YUDEN CO LTD), 7.Oktober 1994,
- PATENT ABSTRACTS OF JAPAN vol. 095, no. 001, 28.Februar 1995 & JP 06 283385 A (TAIYO YUDEN CO LTD), 7.Oktober 1994,

## Beschreibung

Die Erfindung betrifft ein passives Netzwerk in Chip-Bauform.

Patent Abstracts of Japan, vol. 095, no.001 (JP 06 283 384 A) offenbart ein Kondensatornetzwerk mit den Merkmalen gemäß dem Oberbegriff des Anspruchs 1.

Ausgehend von bereits bestehenden Bauformen sowie Fertigungsverfahren und -einrichtungen sollen in einem Baukastensystem passive Netzwerke in Chip-Bauform geschaffen werden.

Gemäß der Erfindung ist dies bei einem passiven Netzwerk in Chip-Bauform in Form eines CCR-(Chip-Capacitor-Resistor-) Array durch die Merkmale des Anspruchs 1 erreicht.

Gemäß einer zusätzlichen Weiterbildung eines passiven Netzwerks in Chip-Bauform gemäß der Erfindung für ein CCRL-(Chip-Capacitor-Resistor-Inductance)Array ist dies durch die Merkmale in den Ansprüchen 1 und 2 erreicht.

Vorteilhafte Weiterbildungen sind Gegenstand der übrigen Ansprüche.

Gemäß der Erfindung sind zur Schaffung von CC-Arrays Electroden einer Anzahl Kondensatoren an der einen Längsseiten-Fläche eines Chip-Plättchens als Anschlüsse herausgeführt, während eine gemeinsame Masse-Elektrode der Anzahl Kondensatoren an beiden Seiten-Flächen des Chip-Plättchens als Masse-Anschlüße herausgefürt ist.

Ein gemäß der Erfindung aufgebautes CCR-Array kann beispielsweise zur Entstörung an Anschlußleitungen von Microcontrollern, vorzugsweise in einem PLCC-(Plastic-Leaded-Chip-Carrier) Gehäuse, oder auch in Verbindung mit integrierten Schaltkreisen (IC's), Hybridkomponenten, u.ä. Verwendung finden.

Ein besonderer Vorteil bei diesem Aufbau eines CCR-Array gemäß der Erfindung besteht ferner darin, daß Spannung führende Anschlüsse, die sogenannten "heißen" Anschlüsse der einzelnen Kondensatoren sehr nahe an den integrierten Schaltkreis (IC) herangeführt werden können. Durch das Heranführen der Spannung führenden Anschlüsse sehr nahe an die integrierte Schaltung ist einer Forderung der EMI-(Electro-Magnetic-Interference) Fachleute genügt, die lautet, je näher ein Kondensator an den Anschlüssen des integrierten Schaltkreises liegt, desto kleiner kann der erforderliche Kapazitätswert ausfallen. Für den Anwender ergeben sich weitere Vorteile hinsichtlich eines beachtlichen Platzgewinns gegenüber Einzelkondensatoren und aufgrund eines geringeren Bestückungsaufwands.

Gemäß der Erfindung brauchen entsprechend dem vorgesehenen Baukastenprinzip für CCR-Arrays zusätzlich nur auf einer Oberfläche eines Chip-Plättchens nebeneinander Widerstandsbereiche in einer Anzahl aufgebracht werden, welche der Anzahl Kondensatoren entspricht. Hierbei sind Anschlüsse der einzelnen Widerstandsbereiche einerseits jeweils mit dem Innenleiter eines zugeordneten Kondensators verbunden und andererseits an der zweiten Längsseiten-Fläche des Chip-Plättchens herausgeführt.

Gemäß der Erfindung kann ein zu einem CCR-Array erweitertes passives Netzwerk zur Entstörung von Leitungen eingesetzt werden. Hierbei liegt ein zusätzlicher Vorteil dieser erweiterten Ausführung des CCR-Array in der höheren Wirksamkeit des bzw. der geschaffenen RC-Glieder.

Bei dem vorgesehenen Baukastensystem kann gemäß der Erfindung ein passives Netzwerk für CCRL-Arrays dadurch geschaffen werden, daß auf die Oberfläche der vorstehend beschriebenen Widerstandsschicht-Bereiche ein Ferrit-Plättchen aufgebracht wird.

Durch diese Erweiterung eines passiven Netzwerks in Form eines CCRL-Array ergibt sich ein zusätzlicher Vorteil, der in der höheren Wirksamkeit des CCRL-Array aufgrund der Addition einer Induktivität L zu den RC-Gliedern liegt.

Um im Hochfrequenzbereich eine Entstörung zu erreichen, werden im allgemeinen Leiter durch Ferrit-Röhrchen gesteckt. Die Wirksamkeit von offenen magnetichen Kreisen, bei welchen eine Leiterbahn parallel zur Ferrit-Oberfläche liegt, ist daher etwas geringer; aus diesem Grund setzt bei dem erfindungsgemäßen Aufbau eines CCRL-Array die Wirksamkeit der offenen magnetischen Kreise erst im höheren Frequenzbereich, d. h. in einem Frequenzbereich über 100MHz, ein.

Besonders vorteilhaft ist ein elektrisches Bauelement in Chip-Bauform, das mit dem geschilderten passiven Netzwerk aufgebaut ist, bei dem auf einer Platine Leiterbahnen angeordnet sind, die mit einem CCR-Array verbunden sind, und daß ein Microcontroller über Anschlüsse mit den Leiterbahnen verbunden ist.

Bei einer Anordnung mit einem CC-Array sind die Leiterbahnen unter dem CC-Array hindurchgeführt, während bei einer Anordnung mit einem CCR-Array die Leiterbahnen nicht unter dem CCR-Array hindurchgeführt sind.

Nachfolgend wird die Erfindung anhand von bevorzugten Ausführungsformen unter Bezugnahme auf die anliegenden Zeichnungen im einzelnen erläutert. Es zeigen:
- Fig.1a: schematisch eine perspektivische, stark vergrößerte Darstellung eines Teils eines passiven Netzwerks als CC-Array zur Erleichterung des Verständnisses der Erfindung;
- Fig.1b: schematisch eine perspektivische, stark vergrößerte Darstellung eines CC-Array in Chip-Bauform;
- Fig.1c: eine Schnittansicht des CC-Array der Fig.1b
- Fig.1d: ein Ersatzschaltbild des CC-Array der Fig.1b und 1c;
- Fig.2a: im Schnitt eine prinzipielle Anordnung eines auf einer Platine angeordneten CC-Array;
- Fig.2b: eine Draufsicht der prinzipiellen Anordnung von Fig.2a;
- Fig.3a: schematisch eine perspektivische, stark vergrößerte Darstellung eines Teils eines CCR-Array gemäß der Erfindung;
- Fig.3b: schematisch eine perspektivische, stark vergrößerte Darstellung des CCR-Array gemäß der Erfindung in Chip-Bauform;
- Fig.3c: eine Schnittansicht des CCR-Array der Fig.3b;
- Fig.3d: ein Ersatzschaltbild eines CCR-Array der Fig.3b und 3c;
- Fig.3e: ein Ersatzschaltbild eines RC-Glieds;
- Fig.4a: im Schnitt eine prinzipielle Anordnung eines auf einer Platine angeordneten CCR-Array;
- Fig.4b: eine Draufsicht der prinzipiellen Anordnung von Fig.4a;
- Fig.5a: schematisch eine perspektivische, stark vergrößerte Darstellung eines Teils eines CCRL-Array gemäß der Erfindung;
- Fig.5b: schematisch eine perspektivische, stark vergrößerte Darstellung des CCRL-Array in Chip-Bauform;
- Fig.5c: eine Schnittansicht des CCRL-Array der Fig.5b;
- Fig.5d und: ein Ersatzschaltbild eines CCRL-Array der Fig.5b 5c, und
- Fig.5e: ein Ersatzschaltbild eines RCL-Glieds.

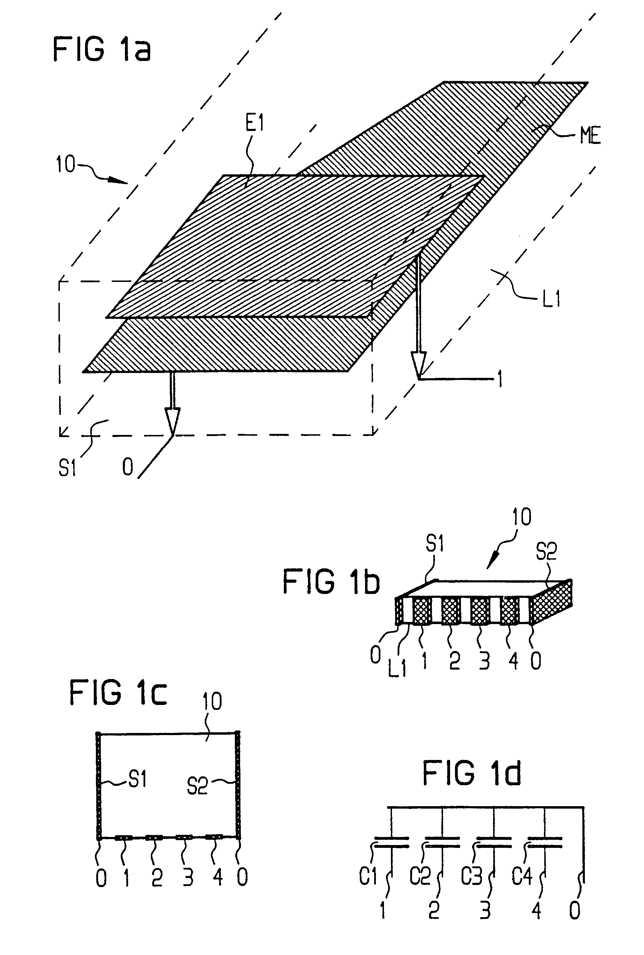

In Fig.1a ist schematisch stark vergrößert eine perspektivische Darstellung eines Teils eines passiven Netzwerks in Form eines CC-Array 10 wiedergegeben. Eine gemeinsame Masse-Elektrode ME ist in Fig.1a an einer Stirnseiten-Fläche S1 als ein Masse-Anschluß 0 ausgebildet, die, wie beispielsweise Fig.1b und 1c zu entnehmen ist, die Stirnseiten-Fläche S1 ganz bedeckt. Ferner ist eine Elektrode E1 beispielsweise eines ersten Kondensators C1 wiedergegeben,von welcher eine durch einen Pfeil angedeutete Leitung, ohne die Masse-Elektrode ME zu berühren, zu einem Außenanschluß 1 in der einen Längsseiten-Fläche L1 des CC-Array-Chip führt.

Fig.1b ist eine schematische perspektivische, stark vergrößerte Darstellung eines Chip 10 in Form eines CC-Array, während Fig.1c eine Schnittansicht des CC-Array 10 ist. In Fig.1b und 1c ist an beiden Stirnseiten-Flächen S1 und S2 jeweils ein Masse-Anschluß 0 vorgesehen. Ferner sind in Fig.1c die an der einen Längsseiten-Fläche L1 vorgesehenen Anschlüsse 1 bis 4 zu erkennen. Fig.1d ist lediglich ein Ersatzschaltbild eines CC-Array mit vier Kondensatoren C1 bis C4, den Anschlüssen 1 bis 4 sowie dem Masse-Anschluß 0.

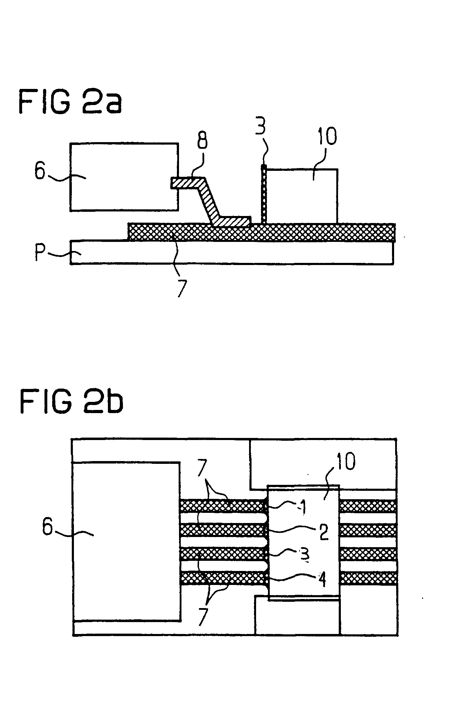

In Fig.2a und 2b ist im Schnitt bzw. in Draufsicht eine prinzipielle Anordnung verschiedener Komponenten wiedergegeben. Auf einer Platine P sind Leiterbahnen 7 vorgesehen, von denen Anschlüsse 8 beispielsweise zu einem Microcontroller 6 führen. Wie der Schnittansicht der Fig.2a zu entnehmen ist, sind die Leiterbahnen 7 unter dem Chip 10 mit dem CC-Array hindurchgeführt. Ferner sind in der Schnittansicht der Fig.2a beispielsweise ein Anschluß 3 und in der Draufsicht der Fig.2b die Anschlüsse 1 bis 4 zu erkennen.

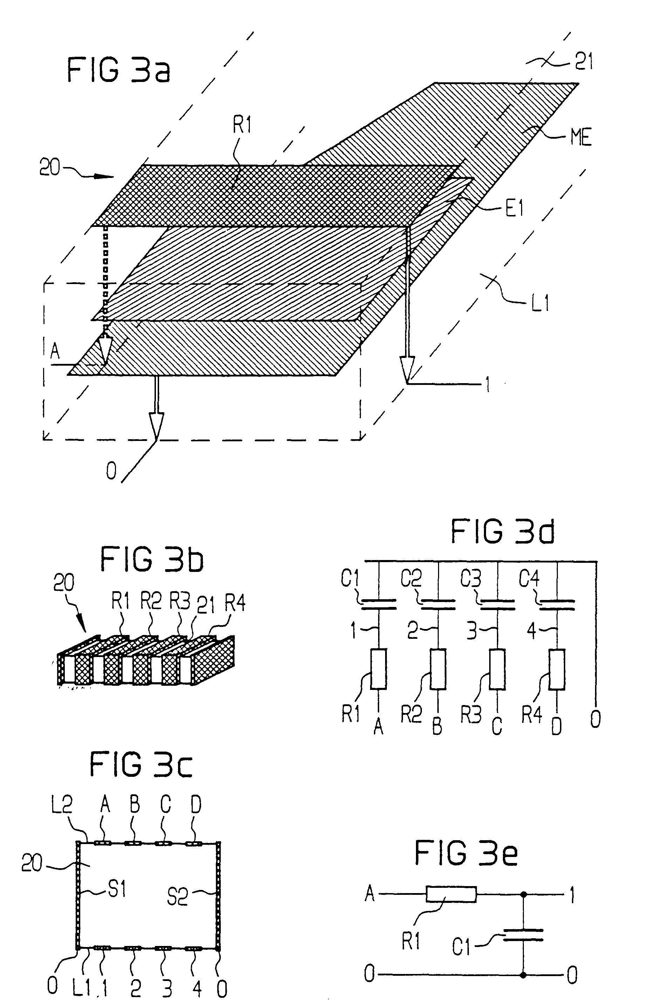

Fig.3a ist eine der Fig.1a entsprechende perspektivische, stark vergrößerte Darstellung eines Teils eines passiven Netzwerks in Form eines CCR-Array, das somit eine Weiterbildung des in Fig.1a wiedergegebenen CC-Array dargestellt. In Weiterbildung des in Fig.1a wiedergegebenen Aufbaus ist in Fig.3a auf einer Oberfläche 21 eines Chip 20 eine beispielsweise einem Widerstand R1 entsprechende Widerstandsschicht aufgebracht.

Wie in der schematischen Darstellung der Fig.3a angedeutet, ist ein Ende der Widerstandsschicht R1 mit dem in der Längsseiten-Fläche L1 ausgebildeten Anschluß 1 verbunden, während das andere Ende der Widerstandsschicht R1, wie durch einen gestrichelten Pfeil angedeutet ist, mit einem an der anderen Längsseiten-Fläche L2 ausgebildeten Anschluß A verbunden ist.

Die Darstellungen in Fig.3b und 3c entsprechen den Darstellungen in Fig.1b und 1 mit dem Unterschied, daß in Fig.3b auf der Oberseite 21 des Chip-Plättchens 20 zusätzlich vier Widerstandsbereiche R1 bis R4 vorgesehen sind, welche, wie der Schnittansicht der Fig.3c zu entnehmen ist, mit an der zweiten Längsseiten-Fläche L2 vorgesehenen Anschlüssen A bis D verbunden sind.

Das Ersatzschaltbild in Fig.3d ist eine Erweiterung des Ersatzschaltbildes in Fig.1d, da zu den vier Kondensatoren C1 bis C4 den vier Widerstandsschicht-Bereichen (R1 bis R4) entsprechende Widerstände R1 bis R4 in Reihe geschaltet sind, welche einerseits mit den an der einen Längsseiten-Fläche L1 vorgesehenen Anschlüssen 1 bis 4 sowie mit den auf der gegenüberliegenden Längseiten-Fläche L2 vorgesehenen Anschlüssen A bis D verbunden sind. Fig.3d ist lediglich ein Ersatzschaltbild eines aus dem Kondensator C1 und dem Widerstand R1 gebildeten RC-Glieds.

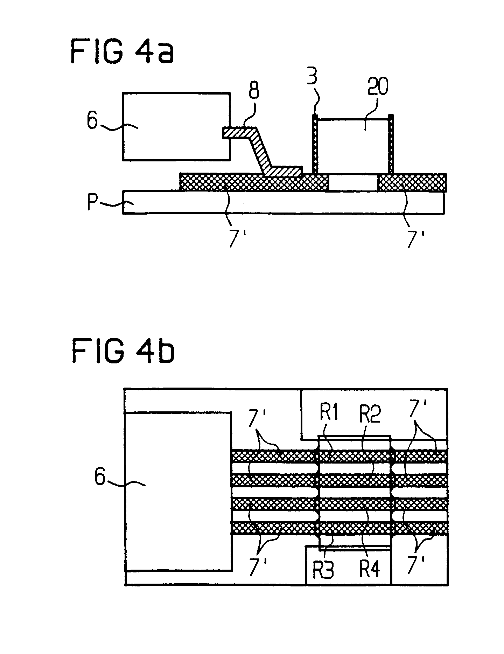

Die Schnittansicht in Fig.4a und die Draufsicht in Fig.4b entsprechen im wesentlichen den Darstellungen in Fig.2a und 2b mit dem Unterschied, daß statt des CC-Array 10 in Fig.2a und 2b nunmehr ein CCR-Array 20 mit einer Widerstandsschicht R auf der Platine P angeordnet ist. Ein weiterer Unterschied zwischen den Darstellungen in den Fig.4a und 4b bezüglich den Darstellungen in Fig.2a und 2b besteht darin, daß unter dem CCR-Array 20 Leiterbahnen 7' nicht hindurchgeführt sind.

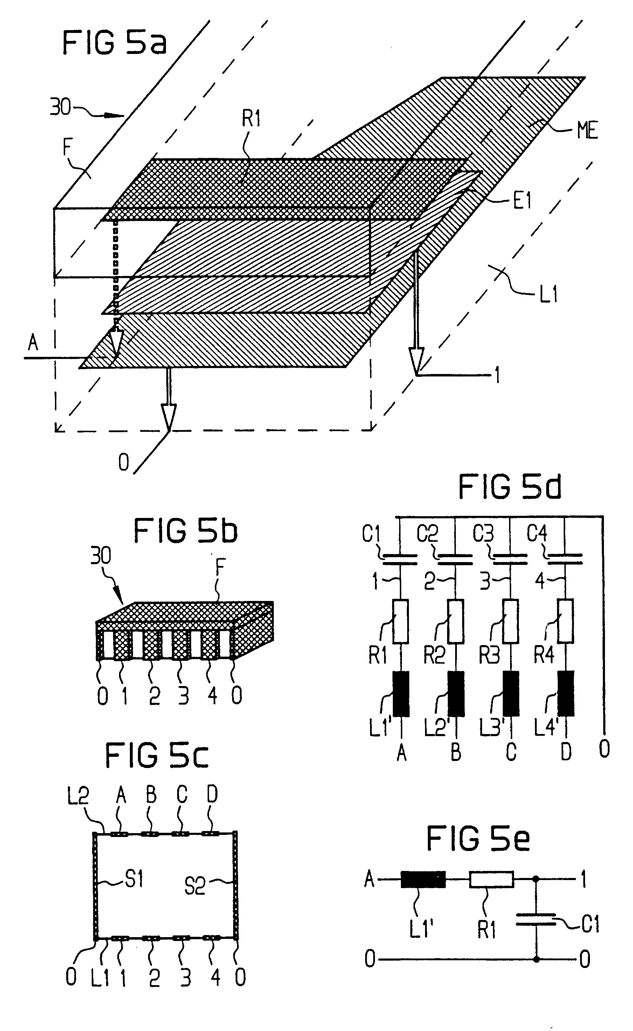

Die perspektivische, stark vergrößerte schematische Darstellung eines Teils eines passiven Netzwerks in Form eines CCLR-Array in Fig.5a ist eine Weiterbildung des in Fig.3a wiedergegebenen CCR-Array, indem auf der Oberfläche der Widerstandsschicht R1 ein Ferrit-Plättchen F aufgebracht. Der Aufbau unter dem Ferrit-Plättchen F ist identisch mit dem anhand von Fig.3a beschriebenen Aufbau des CCR-Array-Chip 20.

Die Darstellung in Fig.5b unterscheidet sich von der Darstellung in Fig.3b lediglich durch das auf die Widerstandsbereiche R1 bis R4 in Fig.3b aufgebrachte Ferrit-Plättchen F. Da das Ferrit-Plättchen F in der Schnittansicht der Fig.5c nicht wiedergegeben werden kann, entspricht die Schnittansicht von Fig.5c derjenigen von Fig.3c.

Das Ersatzschaltbild des CCRL-Array in Fig.5d ist wie ein Vergleich mit dem Ersatzschaltbild des CCR-Array in Fig.3d zeigt, um vier zu den Widerständen R1 bis R4 in Reihe geschaltete Induktivitäten L1' bis L4' erweitert. Fig.5e gibt lediglich ein Ersatzschaltbild eines aus der Induktivität L1', dem Widerstand R1 und dem Kondensator C1 gebildeten RCL-Glieds wieder.

## Patentansprüche

1. Passives Netzwerk in Chip-Bauform,
wobei bei einem CC-Array Elektroden (E1) einer Anzahl Kondensatoren (C1 bis C4) an der einen Längsseiten-Fläche (L1) eines Chip-Plättchens (10) des CC-Arrays als Anschlüsse (1 bis 4) und eine gemeinsame Masse-Elektrode (ME) der Anzahl Kondensatoren (C1 bis C4) als Masse-Anschlüße (0) an beiden Stirnseiten-Flächen (S1, S2) des Chip-Plättchens (10) herausgeführt sind,
**dadurch gekennzeichnet, daß** das CCR-Array als CC-Array ausgebildet ist, wozu zusätzlich auf einer Oberfläche (21) des Chip-Plättchens (20) entsprechend der Anzahl Kondensatoren (C1 bis C4) nebeneinander Widerstandsbereiche (R1 bis R4) aufgebracht sind, deren Anschlüsse zum einen jeweils mit der Elektrode eines zugeordneten Kondensators (C1 bis C4) verbunden sind und zum anderen an der anderen Längsseiten-Fläche (L2) des Chip-Plättchens (20) herausgeführt sind.

2. Passives Netzwerk nach Anspruch 1,
**dadurch gekennzeichnet, daß** das CCR-Array als CCRL-Array ausgebildet ist, wozu auf die Oberfläche der Widerstandsschicht-Bereiche (R1 bis R4) ein Ferrit-Plättchen (F) aufgebracht ist.

3. Passives Netzwerk nach Anspruch 1 oder 2,
**dadurch gekennzeichnet, daß**
die Anzahl an passiven Elementen (C, R, L) eines Chip ein Vielfaches von 2 oder 5 ist.

4. Elektrisches Bauelement in Chip-Bauform mit einem passiven Netzwerk nach einem der Ansprüche 1 bis 3,
**dadurch gekennzeichnet, daß**
auf einer Platine (P) Leiterbahnen (7,7') angeordnet sind, die mit dem CCR-Array (20) oder dem CCRL-Array (30) verbunden sind, und daß ein Microcontroller (6) über Anschlüsse (8) mit den Leiterbahnen (7,7') verbunden ist.

5. Elektrisches Bauelement nach Anspruch 4,
**dadurch gekennzeichnet, daß**
bei einer Anordnung mit einem CCR-Array (20) die Leiterbahnen (7') nicht unter dem CCR-Array hindurchgeführt sind.

## Claims

1. Passive network of chip design,
in which case, in a CC array, electrodes (E1) of a number of capacitors (C1 to C4) are routed out as connections (1 to 4) at one long-side face (L1) of a chip lamina (10) of the CC array and a common earth electrode (ME) of the number of capacitors (C1 to C4) is routed out as earth connections (0) at both end-side faces (S1, S2) of the chip lamina (10),
**characterized in that** the CC array is designed as a CCR array, for which purpose resistor regions (R1 to R4) are additionally applied next to one another on a surface (21) of the chip lamina (20) in accordance with the number of capacitors (C1 to C4), the connections of which resistor regions on the one hand are respectively connected to the electrode of an assigned capacitor (C1 to C4) and on the other hand are routed out at the other long-side face (L2) of the chip lamina (20).

2. Passive network according to Claim 1,
**characterized in that** the CCR array is designed as a CCRL array, for which purpose a ferrite lamina (F) is applied to the surface of the resistor layer regions (R1 to R4).

3. Passive network according to Claim 1 or 2,
**characterized in that**
the number of passive elements (C, R, L) of a chip is a multiple of 2 or 5.

4. Electrical component of chip design with a passive network according to one of Claims 1 to 3,
**characterized in that**
conductor tracks (7, 7') are arranged on a circuit board (P), which conductor tracks are connected to the CCR array (20) or the CCRL array (30), and **in that** a microcontroller (6) is connected to the conductor tracks (7, 7') via connections (8).

5. Electrical component according to Claim 4,
**characterized in that**
in the case of an arrangement with a CCR array (20), the conductor tracks (7') are not routed through below the CCR array.

## Revendications

1. Réseau passif sous forme de puce,
dans lequel pour un réseau CC des électrodes d'un certain nombre de condensateurs (C1 à C4) sont sorties sur l'une des faces (L1) des grands côtés d'une plaquette (10) à puce du réseau CC, en tant que bornes (1 à 4) et -une électrode (ME) de masse commune au nombre de condensateurs (C1 à C4), servant de bornes de masse et sorties sur les deux faces (S1,S2) des côtés frontaux de la plaquette (10) à puce, **caractérisé en ce que** le réseau CC est constitué en réseau CCR, des zones (R1 à R4) juxtaposées de résistance étant déposées à cet effet en plus sur une surface (21) de la plaquette (20) à puce, en correspondance au nombre des condensateurs (C1 à C4), zones de résistance dont les formes sont reliées d'une part respectivement à l'électrode d'un condensateur (C1 à C4) associé et d'autre part, à l'autre face (L2) de grands côtés de la plaquette (20) à puce.

2. Réseau passif suivant la revendication 1, **caractérisé en ce que** le réseau CCR est constitué en réseau CCRL, une plaquette (F) de ferrite étant déposée à cet effet à la surface des zones (R1 à R4) de couches résistives.

3. Réseau passif suivant les revendications 1 et 2, **caractérisé en ce que** le nombre d'éléments (C, R, L) passif d'une puce est un multiple de 2 ou de 5.

4. Composant électrique sous forme de puce ayant un réseau passif suivant l'une des revendications 1 à 3, **caractérisé en ce qu'**il est disposé sur une platine (P) des pistes (7,7') conductrices, qui sont reliées au réseau (20) CCR ou au réseau (30) CCRL et **en ce qu'**un micro-contrôleur (6) est relié aux pistes (7,7') conductrices par des bornes (8).

5. Composant électrique selon la revendication 4, **caractérisé en ce que** pour un agencement ayant un réseau (20) CCR, les pistes (7') conductrices ne passent pas en dessous du réseau CCR.
